# EUROPÄISCHE PATENTSCHRIFT

(11) **EP 0 966 100 B1**
(45) Veröffentlichungstag und Bekanntmachung des Hinweises auf die Patenterteilung: **18.04.2007**
(21) Anmeldenummer: 99110721.0
(22) Anmeldetag: 04.06.1999
(51) Int. Cl.: H03G 3/32, H03G 3/34

(54) **Verfahren und Einrichtung zur Beeinflussung der Lautstärke von Audiowiedergabegeräten in Kraftfahrzeugen**
Method and means for influencing the volume of audio reproducing devices in motor vehicles
Procédé et dispositif pour agir sur le volume d'un appareil de reproduction audio dans un véhicule automobile

(30) Priorität: 18.06.1998 DE 19827197
(43) Veröffentlichungstag der Anmeldung: 22.12.1999
(73) Patentinhaber: Volkswagen Aktiengesellschaft, 38436 Wolfsburg (DE)
(72) Erfinder: Crull, Torsten, 38106 Braunschweig (DE); Schaaf, Klaus Dr., 38116 Braunschweig (DE)

(56) Entgegenhaltungen:
- EP-A- 0 483 956
- EP-A- 0 623 995
- DE-C- 4 338 357
- US-A- 4 359 604
- US-A- 4 677 389
- US-A- 5 243 659

## Beschreibung

Die Erfindung betrifft ein Verfahren sowie eine Einrichtung zur Beeinflussung der Lautstärke von Audiowiedergabegeräten in Kraftfahrzeugen gemäß Oberbegriff der Patentansprüche 1 und 8.

Verfahren zur Lautsprechereinstellung bzw. Beeinflussung in Kraftfahrzeugen sind vielfach bekannt. Sie dienen in den meisten Fällen dazu, abhängig von Nebengeräuschen, die in Kraftfahrzeugen durch Fahrgeräusche oder Windgeräusche entstehen bzw. entstehen können, die Lautstärke der Audioanlage anzupassen. Das heißt bei lauten Innengeräuschen findet eine Anhebung der Lautstärkeregelung beispielsweise beim Autoradio oder aber auch bei der Telefonanlage mit Freisprecheinrichtung statt.

Aus der US 5,243,659 ist ein Verfahren und eine Einrichtung zur Beeinflussung der Lautstärke von Audiogeräten in Kraftfahrzeugen bekannt, wobei die Audiowiedergabe in bestimmten Situationen unterbrochen wird.

Aus der EP 0 623 995 A1 ist eine Anordnung zur geräuschabhängigen Regelung der Lautstärke eines Autoradios bekannt, wobei die Lautstärke abhängig von vorhandenen Störgeräuschen erhöht wird, d. h. je größer die Störgeräusche, desto lauter wird das Autoradio.

Aus der DE 43 07 446 A1 ist ein Verfahren zur Lautsprechereinstellung bekannt, bei welchem der Lautstärkepegel an den Geräuschpegel innerhalb des Fahrzeuges angepaßt wird, in dem der Lautstärkepegel stets über dem Geräuschpegel liegen soll. Nachteilig ist hierbei, daß jedwede Unterhaltung bzw. jedwede Art von Gesprächen der Fahrzeuginsassen untereinander unter Umständen völlig unterbunden wird.

Aus der EP 0 721 178 A2 ist ein System bekannt, welches zur Verbesserung der Akustik innerhalb von Fahrzeugen eine Echounterdrückung verwendet. Diese kann entweder die reine Audiowiedergabe oder aber auch den Telefonbetrieb betreffen.

Aus der EP 0 483 956 A2 ist eine Zusammenschaltung der Verstärker von Radio und Telefon bekannt, um eine gemeinsame und aufeinander abgestimmte Beeinflussung der beiden Geräte bzw. Gerätegattungen zu ermöglichen.

Solche Systeme werden oftmals bei Freisprechanlagen innerhalb von Kraftfahrzeugen verwendet und schalten beispielsweise beim Telefonieren das Autoradio stumm.

Aus der EP 0 611 089 A2 ist ebenfalls ein Kommunikationssystem bekannt, welches wie die bereits oben genannte Offenlegungsschrift den Lautstärkepegel beispielsweise auch beim Telefonieren über den Geräuschpegel innerhalb des Fahrzeuges hebt. Dabei wird durch Filterung mit Hilfe adaptiver Filter eine Verbesserung der Wiedergabequalität durch Geräuschreduktion erzielt. Das heißt eine Lautstärkepegelanhebung alleine findet hierbei nicht statt, sondern es findet eine aktive Geräuschreduktion beispielsweise durch Gegenbeschallung oder dergleichen statt.

Aus der EP 0 580 157 A1 ist ein Lautstärkekontrollsystem bekannt, welches jedoch ausschließlich für sprachgesteuerte Verkehrsleitsysteme anzuwenden ist. Bei sprachgesteuerten Eingabesystemen, wie beispielsweise beim Verkehrsleitsystem, welches Funktionen ausführen soll, die nicht manuell sondern in Form gesprochener Befehle abgerufen werden, ist natürlich eine entsprechende Anpassung bzw. Berücksichtigung des Umgebungsgeräuschschalls notwendig.

Nachteilig ist bei allen diesen bekannten Einrichtungen und Verfahren, daß das Ziel lediglich die Anpassung des Lautstärkepegels an die Umgebungsgeräusche ist. Dies kann natürlich dazu führen, daß der Geräuschpegel, der dann insgesamt im Fahrzeug entsteht, zu einer starken Belastung bzw. Beeinträchtigung des Fahrzeugführers führen kann. Zumindest aber sind automatisch einstellende Lautstärkepegelanhebungen oftmals unkomfortabel.

Der vorliegenden Erfindung liegt daher die Aufgabe zugrunde, ein Verfahren sowie eine Einrichtung der gattungsgemäßen Art dahingehend weiterzubilden, daß das System insgesamt komfortabler ist, und Gespräche der Fahrzeuginsassen untereinander nicht beeinträchtigt oder behindert werden.

Die gestellte Aufgabe ist hinsichtlich eines Verfahrens der gattungsgemäßen Art erfindungsgemäß durch die Merkmale des Patentanspruches 1 gelöst.

Weitere vorteilhafte Ausgestaltungen des erfindungsgemäßen Verfahrens sind in den abhängigen Ansprüchen 2-7 angegeben.

Hinsichtlich einer Einrichtung der gattungsgemäßen Art ist die gestellte Aufgabe erfindungsgemäß durch die Merkmale des Patentanspruches 8 gelöst. Weitere vorteilhafte Ausgestaltungen der Einrichtung sind in den abhängigen Ansprüchen 9 und 10 angegeben.

Kern der Erfindung ist in verfahrensgemäßer Hinsicht, daß abhängig von der Wahrnehmung verbaler, akustischer Signale von Fahrzeuginsassen, womit Gespräche derselben untereinander gemeint sind, die Lautstärke der Audiowiedergabegeräte, wie Radio, CD-Player, Fahrerinformationssystem und dergleichen so lange zu reduzieren und reduziert zu halten, so lange innerhalb eines beliebigen Zeitfensters, d. h. einer bestimmten Dauer die besagten verbalen, akustischen Signale vorliegen. Dies bedeutet, daß sobald registrierbar ist, daß sich Fahrzeuginsassen untereinander besprechen, mit nur einer geringen Zeitverzögerung oder nahezu unmittelbar der Lautstärkepegel von Radio, Kassetten oder CD-Player oder Telefonanlagen derartig reduziert wird, daß eine Unterhaltung ohne störende Stimmanhebung möglich ist. Hierbei soll der Lautstärkepegel auch bei kurzen Sprechpausen zumindest so lange in der besagten Form niedrig gehalten werden, solange die Unterhaltung auch bei Vorliegen kleinerer Sprechpausen fortgeführt wird. Diese Sprechpausen werden von dem entsprechend ausgelegten Zeitfenster überdeckt, so daß kürzere Sprechpausen noch nicht zu einer Anhebung des Lautstärkepegels führen.

In weiterer vorteilhafter Ausgestaltung der verfahrensgemäßen Erfindung erfolgt die entsprechende Lautstärkereduktion am Beginn eines Gespräches oder am Beginn des Vorliegens von verbal akustischen Signalen, um einen einstellbaren Wert vorzunehmen. Das heißt das Maß der Lautstärkereduktion kann zuvor eingestellt werden und wird für die Dauer des Vorliegens der besagten Signale, d. h. für die Dauer des Gespräches im Sinne des Anspruchs 1 auf diesem reduzierten Wert verbleibend gehalten.

Es ist jedoch auch denkbar, daß eine Lautstärkereduktion automatisch angepaßt erfolgt, die sich insgesamt an der vorliegenden Gesamtgeräuschkulisse innerhalb des Fahrzeuges und an der Lautstärke des Gespräches orientiert.

In weiterer vorteilhafter Ausgestaltung des erfindungsgemäßen Verfahrens kann der Wert der Lautstärkereduktion in der besagten Weise von der Lautstärke der verbal akustischen Signale abhängig sein.

Weiterhin ist es vorteilhaft, daß alle Wiedergabe- bzw. alle Audiogeräte in einem Fahrzeug im Sinne der in Anspruch 1 erzielten Funktion miteinander und untereinander beeinflußbar sind. Dies hat den Vorteil, daß sämtliche Geräte, die Musik oder Sprachnachrichten wiedergeben, dieser Funktion unterliegen, so daß unabhängig davon, welches Gerät gerade eingeschaltet ist, grundsätzlich bei einem gewünschten Gespräch der Fahrzeuginsassen eine Lautstärkereduktion der besagten Wiedergabegeräte vorgenommen wird.

Nach einer bevorzugten Ausbildung der Erfindung ist weiterhin vorgesehen, daß nach Beendigung des Gespräches eine sofortige Rückschaltung der Lautstärke der Wiedergabegeräte auf die ursprünglich eingestellte Lautstärke erfolgt. Des weiteren kann jedoch auch vorgesehen sein, daß die Lautstärke nach Gesprächsende nicht ruckartig auf die ursprüngliche Lautstärke gebracht wird, sondern kontinuierlich oder in Stufen hochgefahren wird. Eine dritte Ausbildung sieht weiterhin vor, daß ein Bedienelement vorgesehen ist, mit dessen Hilfe die reduzierte Lautstärke manuell hochgefahren wird.

Kern hinsichtlich der einrichtungsgemäßen Erfindung ist, daß ein Mikrofonsystem vorgesehen ist, welches von Fahrzeuginsassen stammende verbal akustische Signale, also Gesprächssignale aufnimmt, und zur Absenkung der Lautstärke von Wiedergabegeräten mit Lautstärkestellmitteln verschaltet ist. Das heißt, die Gesprächssignale der Fahrzeuginsassen untereinander werden durch ein Mikrofonsystem erfaßt, welches sodann Lautstärkestellmittel beaufschlagt und die verfahrensgemäße Vorgehensweise realisiert. Hierzu können Mikrophone bereits vorhandener Systeme, wie zum Beispiel von Sprachkommunikationssystemen, Systeme zur aktiven Geräuschkompensation oder Freisprechanlagen von Mobiltelefonen, genutzt werden.

Dabei kann es in einrichtungsgemäßer Weise von Vorteil sein, daß alle bordeigenen Wiedergabegeräte durch ein Fahrzeugbussystem informations- und regeltechnisch miteinander verbunden sind, derart, daß alle aktiven Wiedergabegeräte durch das besagte Mikrofonsystem beeinflußbar sind. Mit anderen Worten heißt dies, daß alle Geräte, welche im Fahrzeuginneren Schall erzeugen, gleich welcher Art, über ein Bussystem informations- und regeltechnisch miteinander verbunden sind, so daß unabhängig davon, welches Gerät eingeschaltet ist, die Lautstärkestellmittel auf das entsprechende Gerät einwirken können, sobald durch das Mikrofonsystem Gespräche registriert werden.

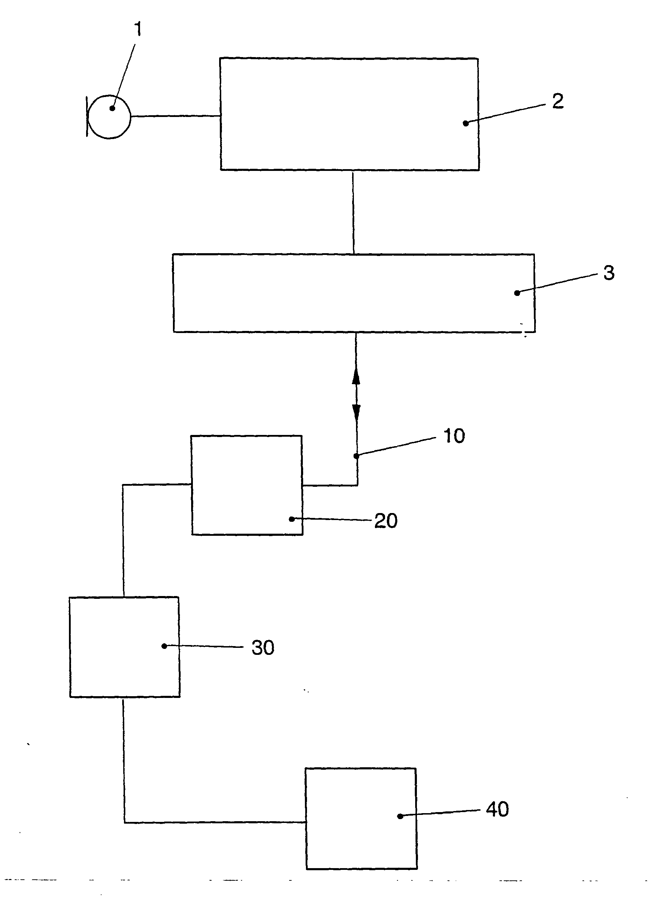

Die Erfindung ist in der Zeichnung dargestellt und nachfolgend näher beschrieben.

Die Abbildung zeigt lediglich die logische Verschaltung der einzelnen Komponenten untereinander, wobei die Darstellung jedoch auch das Verfahren deutlich macht.

Die Gesprächssignale der Fahrzeuginsassen, d. h. die verbal akustischen Signale werden durch ein mehr oder weniger auf diese Aufgabe appliziertes Mikrofon 1 erfaßt. Eine solche Mikrofonanlage kann entweder im Kraftfahrzeug durch mehrere miteinander verschaltete Mikrofone repräsentiert werden, oder aber auf andere Weise. Die auf diese Weise erfaßten verbal akustischen Signale, d. h. die Gesprächssignale der Fahrzeuginsassen, werden von dem Mikrofon 1 bzw. von der Mikrofonanlage 1 an eine Gesprächserfassungseinheit 2 weitergemeldet. In dieser Gesprächserfassungseinheit 2 findet eine logische Trennung bzw. Unterscheidung von verbal akustischen Signalen von übrigen Geräuschen oder Musik oder anderweitig vorliegenden akustischen Signalen statt. Werden nun Gesprächssignale erfaßt, und auch als solche entsprechend erkannt, nämlich als von den Fahrzeuginsassen stammend und nicht beispielsweise aus dem Radio, dann findet eine Beaufschlagung eines damit logisch verschalteten Lautstärkestellmittels 3 statt. Dieses Lautstärkestellmittel 3 kann beispielsweise bei der Verwendung eines bordeigenen Bussystems das Lautstärkestellsignal informationsmäßig auf ein solches Bussystem 10 aufschalten. An diesem Bussystem angeschlossen sind die verschiedenen Wiedergabegeräte, wie Radio 20, CD-Player 30, Kassettenspieler 40 und dergleichen mehr. Die Verbindung mit dem Bussystem kann bedeuten, daß jedes Gerät eine entsprechend eigene Adressierung erhält. Zweckmäßigerweise sollte das Bussystem 10 dann für den Informations- und Stellsignalaustausch zwischen Lautstärkestellmittel 3 und den einzelnen Wiedergabegeräten bidirektional sein. Das heißt das Lautstärkestellmittel 3 muß Information darüber haben, welches Wiedergabegerät gerade aktiv ist. Sodann wird bei einer entsprechenden Erfassung eines Gespräches im Lautstärkestellmittel 3 ein entsprechendes Lautstärkereduktionssignal für das momentan aktive Wiedergabegerät bzw. einen Verstärker für alle Wiedergabegeräte erzeugt und dieses Stellsignal auf das Bussystem gegeben. Das entsprechend aktive Wiedergabegerät erkennt sodann an der über das Bussystem 10 mitgeteilten Adressierung, für welches Gerät das Stellsignal gemeint ist. Nach Erfassen des entsprechenden Stellsignals bzw. der entsprechenden Stellsignalinformation wird das betreffende Wiedergabegerät seinen Lautstärkepegel so weit nach unten fahren, daß das unter den Fahrzeuginsassen geführte Gespräch nicht gestört wird. Dabei kann über das Bussystem entweder das Lautstärkestellsignal direkt auf das entsprechende Wiedergabegerät einwirken, oder aber über das Bussystem erfolgt lediglich die Übersendung der elektronischen Information, daß das besagte Gerät den Lautstärkepegel zurückfahren soll. Hierbei würden dann entsprechende Lautstärkestellmittel sich innerhalb des Wiedergabegerätes oder im gemeinsamen Verstärker befinden.

Im letztgenannten Fall würde das System an den einzelnen Wiedergabegeräten keine bauliche Veränderung bedingen. Das heißt es könnten Standardgeräte mit Bussystemanschluß verwendet werden.

Insgesamt ist das System einfach aufgebaut und dadurch störunanfällig. Die erfindungsgemäße Lautstärkereduktion während Gesprächen ist dabei komfortabel und läuft überdies automatisch ab, so daß beim Wunsch ein Gespräch zu führen, der Fahrzeugführer nicht zusätzlich wiederum das Wiedergabegerät leiser drehen muß. Dies führt insgesamt auch zur Erhöhung der Sicherheit innerhalb des Fahrzeuges im Hinblick auf die beanspruchte Konzentration des Fahrzeugführers.

## Patentansprüche

1. Verfahren zur Beeinflussung der Lautstärke von Audiowiedergabegeräten (20, 30, 40) in Kraftfahrzeugen mittels eines Lautstärkeverstellmittels (3),
**dadurch gekennzeichnet,**
**dass** abhängig von der Wahrnehmung verbaler akustischer Signale der Fahrzeuginsassen mittels einer Gesprächserfassungseinheit (2) innerhalb des Fahrzeugraumes, die Lautstärke der Audiowiedergabegeräte (20, 30, 40, ...) so lange reduziert wird und reduziert bleibt, solange innerhalb eines beliebigen ggf. einstellbaren Zeitfensters die besagten verbalen akustischen Signale vorliegen, wobei mittels der Gesprächserfassungseinheit (2) eine logische Trennung bzw. Unterscheidung von verbal akustischen Signalen der Fahrzeuginsassen von übrigen Geräuschen, Musik oder verbal akustischen Geräuschen des Audiowiedergabegerätes (20, 30, 40) stattfindet.

2. Verfahren zur Beeinflussung der Lautstärke von Audiowiedergabegeräten nach Anspruch 1,
**dadurch gekennzeichnet,**
**dass** am Beginn, d. h. bei beginnendem Vorliegen von verbal akustischen Signalen im Fahrzeug die Lautstärkereduktion um einen einstellbaren Wert erfolgt, und für die Dauer des Vorliegens der besagten Signale im Sinne des Anspruches 1 auf diesem reduzierten Wert verbleibt.

3. Verfahren zur Beeinflussung der Lautstärke von Audiowiedergabegeräten nach Anspruch 1 oder 2,
**dadurch gekennzeichnet,**
**dass** der Wert der Lautstärkereduktion von der Lautstärke der besagten verbal-akustischen Signale abhängig ist.

4. Verfahren zur Beeinflussung der Lautstärke von Audiowiedergabegeräten nach einem oder mehreren der vorhergehenden Ansprüche,
**dadurch gekennzeichnet,**
**dass** alle Wiedergabe- bzw. alle Audiogeräte in einem Fahrzeug im Sinne der in Anspruch 1 erzielten Funktion miteinander und untereinander beeinflussbar sind.

5. Verfahren zur Beeinflussung der Lautstärke von Audiowiedergabegeräten nach einem oder mehren der vorhergehenden Ansprüche, **dadurch gekennzeichnet, dass** nach Ende des Vorliegens der verbal akustischen Signale eine sofortige Rückschaltung auf die ursprüngliche Lautstärke der Audiowiedergabegeräte (20, 30, 40, ...) erfolgt.

6. Verfahren zur Beeinflussung der Lautstärke von Audiowiedergabegeräten nach einem der Ansprüche 1 bis 4, **dadurch gekennzeichnet, dass** nach Ende des Vorliegens der verbal akustischen Signale ein kontinuierliches oder stufenweises Hochfahren auf die ursprüngliche Lautstärke der Audiowiedergabegeräte (20, 30, 40, ...) erfolgt.

7. Verfahren zur Beeinflussung der Lautstärke von Audiowiedergabegeräten nach einem der Ansprüche 1 bis 6, **dadurch gekennzeichnet, dass** nach der Reduzierung der Lautstärke der Audiowiedergabegeräte (20, 30, 40, ...) ein manuelles Hochfahren mittels eines Bedienelementes bis auf die ursprüngliche Lautstärke der Audiowiedergabegeräte (20, 30, 40, ...) möglich ist.

8. Einrichtung zur Beeinflussung der Lautstärke von Audiowiedergabegeräten (20, 30, 40) in Kraftfahrzeugen, umfassend ein Mikrofonsystem (1) und ein Lautstärkeverstellmittel (3),
**dadurch gekennzeichnet,**
**dass** abhängig von der Wahrnehmung verbaler akustischer Signale der Fahrzeuginsassen mittels einer Geräuscherfassungseinheit (2) innerhalb des Fahrzeugraumes die Lautstärke der Audiowiedergabegeräte (20, 30, 40) solange reduziert wird und reduziert bleibt, solange innerhalb eines beliebigen, gegebenenfalls einstellbaren Zeitfensters die besagten verbalen akustischen Signale vorliegen, wobei mittels der Gesprächserfassungseinheit (2) eine logische Trennung bzw. Unterscheidung von verbal akustischen Signalen der Fahrzeuginsassen von übrigen Geräuschen, Musik oder verbal akustischen Geräuschen des Audiowiedergabegerätes (20, 30, 40) stattfindet.

9. Einrichtung zur Beeinflussung der Lautstärke von Audiowiedergabegeräten in Kraftfahrzeugen nach Anspruch 8, **dadurch gekennzeichnet, dass** die bordeigenen Wiedergabegeräte (20, 30, 40, ...) durch ein Fahrzeugbussystem (10) informations- und regeltechnisch miteinander verbunden sind, derart, dass alle aktiven Wiedergabegeräte (20, 30, 40, ...) durch das besagte Mikrofonsystem (1) beeinflussbar sind.

10. Einrichtung zur Beeinflussung der Lautstärke von Audiowiedergabegeräten in Kraftfahrzeugen nach Anspruch 9, **dadurch gekennzeichnet, dass** die bordeigenen Wiedergabegeräte (20, 30, 40, ...) einen gemeinsamen Verstärker aufweisen.

## Claims

1. Method for influencing the volume of audio reproduction appliances (20, 30, 40) in motor vehicles using a volume adjusting means (3),
**characterized**
**in that** the perception of verbal audio signals from the vehicle occupants using a voice detection unit (2) within the vehicle compartment is taken as a basis for reducing the volume of the audio reproduction appliances (20, 30, 40, ...), and keeping it reduced, for as long as said verbal audio signals are present within an arbitrary, possibly adjustable, time window, where the voice detection unit (2) is used for logically separating or distinguishing verbal audio signals from the vehicle occupants from other sounds, music or verbal audio sounds from the audio reproduction appliance (20, 30, 40).

2. Method for influencing the volume of audio reproduction appliances according to Claim 1,
**characterized**
**in that** in the beginning, i.e. when verbal audio signals begin to be present in the vehicle, the volume reduction is made by an adjustable value and remains at this reduced value for the duration of said signals being present within the context of Claim 1.

3. Method for influencing the volume of audio reproduction appliances according to Claim 1 or 2,
**characterized**
**in that** the value of the volume reduction is dependent on the volume of said verbal audio signals.

4. Method for influencing the volume of audio reproduction appliances according to one or more of the preceding claims,
**characterized**
**in that** all the reproduction appliances or all the audio appliances in a vehicle can be influenced by means of one another and among one another within the context of the function achieved in Claim 1.

5. Method for influencing the volume of audio reproduction appliances according to one or more of the preceding claims, **characterized in that** when the verbal audio signals are no longer present there is an immediate return to the original volume of the audio reproduction appliances (20, 30, 40, ...).

6. Method for influencing the volume of audio reproduction appliances according to one of Claims 1 to 4, **characterized in that** when the verbal audio signals are no longer present there is a continuous or gradual increase to the original volume of the audio reproduction appliances (20, 30, 40, ...).

7. Method for influencing the volume of audio reproduction appliances according to one of Claims 1 to 6, **characterized in that** when the volume of the audio reproduction appliances (20, 30, 40, ...) has been reduced a manual increase using a control element is possible up to the original volume of the audio reproduction appliances, (20, 30, 40, ...).

8. Device for influencing the volume of audio reproduction appliances (20, 30, 40) in motor vehicles, comprising a microphone system (1) and a volume adjusting means (3),
**characterized**
**in that** the perception of verbal audio signals from the vehicle occupants using a voice detection unit (2) within the vehicle compartment is taken as a basis for reducing the volume of the audio reproduction appliances (20, 30, 40), and keeping it reduced, for as long as said verbal audio signals are present within an arbitrary, possibly adjustable, time window, where the voice detection unit (2) is used for logically separating or distinguishing verbal audio signals from the vehicle occupants from other sounds, music or verbal audio sounds from the audio reproduction appliance (20, 30, 40).

9. Device for influencing the volume of audio reproduction appliances in motor vehicles according to Claim 8, **characterized in that** the on-board reproduction appliances (20, 30, 40, ...) are connected to one another by a vehicle bus system (10) for information and control purposes such that all the active reproduction appliances (20, 30, 40, ...) can be influenced by said microphone system (1).

10. Device for influencing the volume of audio reproduction appliances in motor vehicles according to Claim 9, **characterized in that** the on-board reproduction appliances (20, 30, 40, ...) have a common amplifier.

## Revendications

1. Procédé servant à influencer le volume des appareils de reproduction audio (20, 30, 40) dans les véhicules automobiles au moyen d'un dispositif de réglage du volume (3),
**caractérisé en ce que**
grâce à une unité de saisie de conversation (2) située à l'intérieur de l'habitacle du véhicule, le volume des appareils de reproduction audio (20, 30, 40,...) peut être réduit et le rester aussi longtemps que les signaux acoustiques verbaux sont disponibles sur un laps de temps choisi ou éventuellement préréglé, en fonction de la reconnaissance de signaux acoustiques verbaux venant des passagers du véhicule, l'unité de saisie de conversation (2) permettant de réaliser une séparation logique ou une différentiation entre les signaux acoustiques verbaux des passagers du véhicule et les autres bruits, musiques ou sons acoustiques verbaux venant des appareils de reproduction audio (20, 30, 40).

2. Procédé servant à influencer le volume des appareils de reproduction audio selon la revendication 1,
**caractérisé en ce que**
le volume est réduit au début, c'est à dire dès que les signaux acoustiques verbaux deviennent disponibles dans le véhicule automobile, selon une valeur réglable au choix, et **en ce que** cette valeur réduite est maintenue pendant toute la période où lesdits signaux sont disponibles au sens de la revendication 1.

3. Procédé servant à influencer le volume des appareils de reproduction audio selon la revendication 1 ou 2,
**caractérisé en ce que**
la valeur de réduction du volume dépend du volume desdits signaux acoustiques verbaux.

4. Procédé servant à influencer le volume des appareils de reproduction audio selon l'une ou plusieurs des précédentes revendications,
**caractérisé en ce que**
tous les appareils de reproduction et tous les appareils audio dans un véhicule automobile sont influençables ensemble et entre eux au sens de la fonction visée par la revendication 1.

5. Procédé servant à influencer le volume des appareils de reproduction audio selon l'une ou plusieurs des précédentes revendications, **caractérisé en ce que** le volume initial des appareils de reproduction audio (20, 30, 40,...) est immédiatement récupéré une fois que les signaux acoustiques verbaux ne sont plus disponibles.

6. Procédé servant à influencer le volume des appareils de reproduction audio selon l'une des revendications 1 à 4, **caractérisé en ce que** le volume s'élève progressivement, par paliers ou de façon continue, jusqu'à atteindre le volume initial des appareils de reproduction audio (20, 30, 40, ...), une fois que les signaux acoustiques verbaux ne sont plus disponibles.

7. Procédé servant à influencer le volume des appareils de reproduction audio selon l'une des revendications 1 à 6, **caractérisé en ce que** suite à la réduction du volume des appareils de reproduction audio (20, 30, 40,...), il est possible d'augmenter manuellement ce volume au moyen d'un élément de commande, jusqu'à atteindre le volume initial des appareils de reproduction audio (20, 30, 40, ...).

8. Dispositif servant à influencer le volume des appareils de reproduction audio (20, 30, 40) dans un véhicule automobile, comprenant un système de micro (1) et un dispositif de réglage du volume
(3), **caractérisé en ce que**
grâce à une unité de saisie de conversation (2) située à l'intérieur de l'habitacle du véhicule, le volume des appareils de reproduction audio (20, 30, 40) peut être réduit et le rester aussi longtemps que les signaux acoustiques verbaux sont disponibles sur un laps de temps choisi ou éventuellement préréglé, en fonction de la reconnaissance de signaux acoustiques verbaux venant des passagers du véhicule, l'unité de saisie de conversation (2) permettant de réaliser une séparation logique ou une différentiation entre les signaux acoustiques verbaux des passagers du véhicule et les autres bruits, musiques ou sons acoustiques verbaux des appareils de reproduction audio (20, 30, 40).

9. Dispositif servant à influencer le volume des appareils de reproduction audio dans un véhicule automobile selon la revendication 8, **caractérisé en ce que** les appareils de reproduction (20, 30, 40, ...) se trouvant à bord sont reliés entre eux par un système de bus pour véhicules (10) permettant un échange des informations et des réglages, si bien que tous les appareils de reproduction (20, 30, 40, ...) peuvent être influencés par ledit système de micro (1).

10. Dispositif servant à influencer le volume des appareils de reproduction audio dans un véhicule automobile selon la revendication 9, **caractérisé en ce que** les appareils de reproduction (20, 30, 40, ...) se trouvant à bord possèdent un amplificateur commun.
